# EUROPÄISCHE PATENTSCHRIFT

(11) **EP 1 646 507 B1**
(45) Veröffentlichungstag und Bekanntmachung des Hinweises auf die Patenterteilung: **15.11.2006**
(21) Anmeldenummer: 04738917.6
(22) Anmeldetag: 16.07.2004
(51) Int. Cl.: B41M 3/14, B41M 1/36, B42D 15/00

(54) **MEHRSCHICHTKÖRPER, VORRICHTUNG UND VERFAHREN ZUR ERZEUGUNG EINES FLÄCHENMUSTERS HOHER AUFLÖSUNG**
MULTI-LAYER BODY, DEVICE AND METHOD FOR PRODUCING A HIGH-RESOLUTION SURFACE PATTERN
CORPS MULTICOUCHE, DISPOSITIF ET PROCEDE POUR PRODUIRE UN MOTIF SUR UNE SURFACE AVEC UNE HAUTE RESOLUTION

(30) Priorität: 21.07.2003 DE 10333255
(43) Veröffentlichungstag der Anmeldung: 19.04.2006
(73) Patentinhaber: Leonhard Kurz GmbH & Co. KG, 90763 Fürth (DE)
(72) Erfinder: BREHM, Ludwig, 91325 Adelsdorf (DE); GEIM, Dieter, 91177 Thalmässing (DE)
(74) Vertreter: Zinsinger, Norbert
(86) Internationale Anmeldenummer: PCT/DE2004/001554
(87) Internationale Veröffentlichungsnummer: WO 2005/009742

(56) Entgegenhaltungen:
- EP-A- 0 687 771
- DE-A- 3 705 988
- US-A- 4 715 623

## Beschreibung

Die Erfindung betrifft ein Verfahren zum Erzeugen eines Flächemusters hoher Auflösung auf einem Substrat, wobei bei dem Verfahren eine Drucksubstanz mittels eines Druckverfahrens musterförmig auf das Substrat aufgebracht wird. Die Erfindung betrifft weiter einen Mehrschichtkörper mit einer mittels eines Druckverfahrens musterförmig auf eine Substratschicht aufgebrachten Musterschicht und eine Vorrichtung zum Erzeugen eines Flächemusters hoher Auflösung, das eine Druckstation zum musterförmigen Aufbringen einer viskosen Drucksubstanz auf einem Substrat aufweist.

Zum Aufbringen einer Drucksubstanz auf einem Substrat werden üblicherweise Tiefdruck-, Offset-, Hochdruck- und Siebdruckverfahren verwendet.

Der Tiefdruck bezeichnet ein Druckverfahren mit Druckelementen, die gegenüber der Formoberfläche tiefergelegt sind. Nach dem vollständigen Einfärben der Druckform wird die Oberfläche von der Druckfarbe befreit, so dass diese nur in den vertieften Stellen zurückbleibt. Die Art der Einfärbung und das Blankrakeln der Oberfläche gestatten keinen reinen Flächendruck, so dass ganze Zeichnungen in Linien, Punkte und Rasterelemente aufgelöst werden. Wegen der unterschiedlichen Tiefe und Größe der einzelnen Druckelemente fassen diese mehr oder weniger Druckfarbe, der Abdruck weist infolgedessen an den verschiedenen Bildstellen unterschiedliche Farbkraft auf.

Um die Auflösung dieser Druckverfahren zu verbessern, wird in DE 37 05 988 A1 vorgeschlagen, als Druckform eine homogene Folie zu verwenden, in die mittels Feinstperforationsverfahren Druckinformationen in Form von Kapillaren als Druckgänge eingebracht werden. Eine niedrigviskose Drucksubstanz wird in die Kapillaren eingebracht und die Drucksubstanz aus den Kapillaren mit einer definierten Druckkraft als Feinstdruck auf den Bedruckstoff aufgebracht. Zur Feinstperforation werden hierbei fokussierte Laserstrahlen mit einem Strahldurchmesser von 1 bis 10 µm verwendet. Als Druckform dient eine 20 bis 50 µm dicke, homogene Folie, beispielsweise eine Kunststoff- oder Metallfolie.

In DE 195 44 099 A1 wird vorgeschlagen, einen mit direkt aneinander liegenden Näpfchen versehenen, transparenten Zylinder als Farb- oder Druckträger zu verwenden, wobei die Näpfchen mit geschmolzener Farbe befüllt werden und anschließend die Farbe durch thermische Beeinflussung in einen festen Zustand gebracht wird.

In DE 197 46 174 C1 wird vorgeschlagen, in Näpfchen kontinuierlich eine flüssige, meniskusbildende Drucksubstanz einzubringen und die Drucksubstanz in den Näpfchen mittels eines von einer energiegebenden Einrichtung induzierten Vorgangs auf einem angenäherten Bedruckstoff zu übertragen.

Bei den oben beschriebenen bekannten Verfahren zur Verbesserung der mittels eines Druckverfahrens erzielbaren Auflösung wird demnach versucht, durch möglichst punktgenaues Aufbringen einer möglichst kleinen Menge an Drucksubstanz die erzielbare Auflösung zu verbessern.

Der Erfindung liegt nun die Aufgabe zugrunde, eine verbesserte Erzeugung eines Flächenmusters hoher Auflösung zu ermöglichen.

Diese Aufgabe wird von einem Verfahren zum Erzeugen eines Flächenmusters hoher Auflösung auf einem Substrat gelöst, bei dem eine Drucksubstanz mittels eines Druckverfahrens musterförmig auf das Substrat aufgebracht wird, bei dem zur Feinstrukturierung des Flächenmusters vor dem Aufbringen der Drucksubstanz in die Oberfläche des Substrats eine mikroskopische Oberflächenstruktur mit einer Vielzahl von Rillen repliziert wird und bei dem die Feinstrukturierung des Flächenmusters durch die jeweils lokal aufgebrachte Auftragemenge an Drucksubstanz und die jeweiligen lokalen Reliefparameter der mikroskopischen Oberflächenstruktur, insbesondere Orientierungsrichtung und Profilform, bestimmt wird. Diese Aufgabe wird weiter von einer Vorrichtung zum Erzeugen eines Flächenmusters hoher Auflösung auf einem Substrat gelöst, die weiter eine Druckstation zum musterförmigen Aufbringen einer Drucksubstanz auf dem Substrat aufweist, die weiter eine vor der Druckstation angeordnete Replizierstation zur Feinstrukturierung des Flächenmusters aufweist, die in die Oberfläche des Substrats eine mikroskopische Oberflächenstruktur mit einer Vielzahl von Rillen repliziert, und bei der die Druckstation die Drucksubstanz derart auf die mikroskopische Oberflächenstruktur des Substrates aufbringt, dass sich eine vorbestimmte Feinstrukturierung des Flächenmusters durch die jeweils lokal aufgebrachte Auftragemenge an Drucksubstanz und die jeweiligen lokalen Reliefparameter der mikroskopischen Oberflächenstruktur, insbesondere Orientierungsrichtung und Profilform, ergibt. Diese Aufgabe wird weiter von einem Mehrschichtkörper gelöst, der eine Substratschicht und eine auf der Substratschicht in Form eines Flächenmusters hoher Auflösung angeordnete Musterschicht aus einer Drucksubstanz aufweist, wobei in die Oberfläche des Substrates zur Feinstrukturierung des Flächenmusters vor dem Aufbringen der Drucksubstanz eine mikroskopische Oberflächenstruktur mit einer Vielzahl von Rillen repliziert ist und die Feinstrukturierung des Flächenmusters durch die jeweils lokal aufgebrachte Auftragemenge an Drucksubstanz und die jeweiligen lokalen Reliefparameter der mikroskopischen Oberflächenstruktur, insbesondere Orientierungsrichtung, Profiltiefe und Profilform, bestimmt ist.

Bei der Erfindung wird demnach eine Verbesserung der Auflösung des entstehenden Druckbildes durch eine gezielte Beeinflussung der Oberflächenstruktur des Substrates bewirkt. Die genaue Form des Flächenmusters ergibt sich durch die Überlagerung dreier Effekte, zum einen der jeweils lokal aufgebrachten Auftragemenge einer Drucksubstanz, den rheologischen Eigenschaften der Drucksubstanz und zum andern der jeweiligen lokalen Relief-Parameter der mikroskopischen Oberflächenstruktur.

Durch die Erfindung lassen sich Auflösungen erzielen, die mit herkömmlichen Drucktechniken nicht erzeugbar sind. So lassen sich beispielsweise durch herkömmliche Tiefdruckverfahren Auflösungen im Bereich von circa 80 µm erzielen. Unter der Verwendung der Erfindung ist es hier möglich, die mittels eines Tiefdruckverfahrens erzielbare Auflösung auf circa 30 µm und weniger zu verbessern. Weitere Vorteile ergeben sich dadurch, dass verbreitete und ausgereifte Druck-Technologien für die Umsetzung der Erfindung verwendbar bleiben. Hierdurch ergeben sich erhebliche Kostenvorteile.

Vorteilhafte Ausgestaltungen der Erfindung sind den Unteransprüchen zu entnehmen.

Besonders vorteilhaft ist es hierbei, eine Drucksubstanz mit einer vordefinierten Viskosität und Affinität zu verwenden. Die Viskosität der Drucksubstanz und die Affinität zwischen Drucksubstanz und Substrat beeinflussen das Fließverhalten der Drucksubstanz. Damit wir das sich ergebende Druckbild auch durch diese Größen beeinflußt. Besonders vorteilhaft ist es hierbei, eine Drucksubstanz mit einer Viskosität von 50 - 150 mPas zu wählen. Weiter ist es möglich, durch gezielte Wahl der Oberflächenspannung von Drucksubstanz und Drucksubstrat (Affinität) die Druckauflösung weiter zu beeinflussen. Bei der Auswahl einer Drucksubstanz, deren Viskosität vorzugsweise in diesem Größenbereich liegt, kommen die oben beschriebenen Effekte besonders zum Tragen, so daß sich ein Druckbild besonders hoher Auflösung erzeugen läßt.

Die Erfindung eignet sich besonders gut zum Aufbringen von Flächenmustem hoher Auflösung auf einen mehrschichtigen Folienkörper. So kann die Erfindung insbesondere bei der Herstellung von Heißpräge-, Laminier- oder Transferfolien verwendet werden. Diese Folien oder auch aus diesen Folien hergestellte Folienelemente können im Sicherheitsbereich, beispielsweise als optische Sicherheitselemente zur Sicherung von Banknoten, Kreditkarten, Ausweispapieren und dergleichen, verwendet werden. Weiter können derartige Folien oder Folienelemente auch im dekorativen Bereich verwendet werden.

Als besonders vorteilhaft hat sich die Anwendung der Erfindung im Bereich der Demetallisierung/partiellen Abtragung von Substrat-Schichten erwiesen. Die durch die Erfindung erreichbare hohe Auflösung sowie der erzielbare hohe Qualitätsstandard sind hier von großem Vorteil. Mittels der Erfindung kann beispielsweise ein Ätzresist, ein Ätzmittel oder eine Waschmaske gemäß eines Flächenmusters hoher Auflösung auf eine partiell zu entfernende Substratschicht aufgebracht werden. Eine weitere vorteilhafte Anwendung besteht darin, mittels der Erfindung organisches Halbleitermaterial als Drucksubstanz in Form eines Flächenmusters hoher Auflösung auf eine Substratschicht aufzubringen, um beispielsweise organische Feldeffekttransistoren (OFETs) zu erzeugen.

Gemäß eines bevorzugten Ausführungsbeispiels der Erfindung wird die Feinstrukturierung des Flächenmusters durch Variation der Orientierungsrichtung der Rillen der mikroskopische Oberflächenstruktur bewirkt. Die Breite eines Flächenbereiches eines Flächenmusters wird hier durch Wahl des Winkels zwischen der Längsachse des Flächenbereiches und der Orientierungsrichtung des zugeordneten Teils der mikroskopischen Oberflächenstruktur bestimmt. So kann die Breite des Flächenbereiches variiert werden, indem in den Flächenbereich Bereiche mit unterschiedlicher Orientierung der Oberflächenstruktur vorgesehen werden. Diese Methode ist hierbei besonders einfach technisch implementierbar und besonders effektiv. Ein lokal auf die mikroskopische Oberflächenstruktur aufgebrachter mikrofeine Drucksubstanz, beispielsweise in Form eines Tropfens, wird in seinem Verlauf durch die mikroskopische Oberflächenstruktur beeinflusst. Auch die rehologisne Eigenschaften der Drucksubstanz üben Einfluß auf die Feinstrukturierung aus. Der durch die mikroskopische Oberflächenstruktur bewirkte asymmetrische Verlauf der Drucksubstanz wird gezielt zur Erhöhung der Auflösung des Flächenmusters ausgenutzt.

Eine besonders große Variationen der Breite des Flächenbereiches des Flächenmusters ist hierbei dadurch erzielbar, indem in dem Flächenbereich mindestens zwei Bereiche mit um 90 Grad gegeneinander verdrehten Orientierungsrichtungen der Oberflächenstruktur vorgesehen werden.

Weiter ist es möglich, die Feinstrukturierung des Musters durch Variation der Profiltiefe der Rillen der mikroskopischen Oberflächenstruktur zu bewirken. Ebenso ist eine Feinstrukturierung des Flächenmusters durch Variation der Profilform der Rillen der mikroskopischen Oberflächenstruktur möglich. Durch Variation der Profiltiefe und der Profilform lässt sich die von einem lokal aufgebrachten mikrofeinen Drucksubstanz-Tropfen eingenommene Benetzungsfläche variieren. Hierdurch lässt sich indirekt die Breite eines Flächenbereiches des Flächenmusters variieren, indem in dem Flächenbereich Bereiche mit unterschiedlichen Profilformen oder unterschiedlichen Profiltiefen der Oberflächenstruktur vorgesehen werden. Weiter lässt sich durch asymmetrische Profilformen im zugeordneten Teil der mikroskopischen Oberflächenstruktur die Zentrierung eines Flächenbereiches des Flächenmusters verändern. Durch derartige asymmetrische Profilformen wird ein asymmetrischer Verlauf des auf die mikroskopische Oberflächenstruktur aufgebrachten mikrofeinen Drucksubstrat-Tropfens bewirkt. Dieser Effekt wird gezielt zu einer weiteren Erhöhung der Auflösung des Flächenmusters eingesetzt.

Es ist möglich, die Feinstrukturierung des Flächenmusters sowohl durch Variation der Orientierungsrichtung der Rillen der mikroskopischen Oberflächenstruktur, durch Variation der Profiltiefe der mikroskopischen Oberflächenstruktur und durch Variation der Profilformen der Rillen der mikroskopischen Oberflächenstruktur zu bewirken. Auch die rheologischen Eigenschaften der Drucksubstanz üben Einfluß auf die Feinstrukturierung aus. Durch eine Kombination der oben beschriebenen Effekte lässt sich so das gewünschte, hochauflösende Muster erzeugen.

Die oben beschriebenen Effekte kommen hierbei insbesondere dann zum Tragen, wenn die Breite der Flächenbereiche kleiner als 50 µm ist.

Besonders vorteilhaft ist es, mittels der Feinstrukturierung benachbarter Flächen durch Variation lokaler Reliefparameter der mikroskopischen Oberflächenstruktur Moiré-Muster zu erzeugen. Derartig hergestellte Moiré-Muster können mittels üblicher Druckverfahren nicht repliziert werden und sind daher als hochwertiges optisches Sicherheitsmerkmal verwendbar. Diese Vorteile ergeben sich ebenfalls bei der Erzeugung eines Mikroschrift-Musters mittels der Feinstrukturierung durch Variation lokaler Reliefparameter der mikroskopischen Oberflächenstruktur. Auch hier ergibt sich ein optisches Sicherheitsmerkmal, das nur schwer nachahmbar ist.

Weiter ist es möglich, durch Variation der Profiltiefe der Rillen der mikroskopischen Oberflächenstruktur einen Bereich mit vordefiniert variierender Dicke der Drucksubstanzschicht zu erzeugen. Dies kann zur Erzeugung von Linsenkörpern ausgenutzt werden: Als Drucksubstanz wird ein hochbrechender Lack verwendet. Durch die Variation der Profiltiefe der Rillen der mikroskopischen Oberflächenstruktur wird beim Aufbringen des hochbrechenden Lacks in diesem Bereich ein Linsenkörper erzeugt.

Das hochauflösende flächendeckende Muster lässt sich besonders einfach erzeugen, wenn die Feinstrukturierung des Flächenmusters durch Variation der Relief-Parameter der mikroskopischen Oberflächenstruktur bei in etwa konstanter Auftragemenge an Drucksubstanz pro Flächeneinheit bewirkt wird. Hierdurch wird der Rechenaufwand verringert, der zur Bestimmung der notwendigen mikroskopischen Oberflächenstruktur und des notwendigen Musters erforderlich ist, gemäß dem die Drucksubstanz auf das Substrat aufzubringen ist, um das vorgegebene hochauflösende Flächenmuster zu erzielen.

Besonders gute Ergebnisse werden dadurch erzielt, dass die mikroskopische Oberflächenstruktur eine Spatialfrequenz von mehr als 50 Rillen/mm, vorzugsweise von 100 bis 1200 Rillen/mm, und eine Profiltiefe von weniger als 2 µm, vorzugsweise von 0,2 bis 1,2 µm hat.

Eine Vorrichtung zum Erzeugen eines Flächenmusters gemäß der Erfindung weist vorzugsweise eine Druckstation mit einer Insetting-Einrichtung auf, um das passergenaue Aufbringen des Drucksubstrats auf die mikroskopische Oberflächenstruktur sicherzustellen. Besonders gute Ergebnisse lassen sich dadurch erzielen, dass die Vorrichtung einen Zentralzylinder aufweist, an dem die Replizierstation und die Druckstation angeordnet sind. Hierdurch wird ein passergenauer Aufdruck erreicht, so dass sich die Auflösung des Flächenmusters weiter verbessert.

Im folgenden wird die Erfindung anhand von mehreren Ausführungsbeispielen unter Zuhilfenahme der beiliegenden Zeichnungen beispielhaft verdeutlicht.
Fig. 1 zeigt ein Ablaufdiagramm, anhand dessen der Ablauf des erfindungsgemäßen Verfahrens verdeutlicht ist.
Fig. 2a bis Fig. 2e zeigen schematische Darstellungen eines Mehrschichtkörpers, der gemäss des erfindungsgemäßen Verfahrens bearbeitet wird.
Fig. 3 zeigt eine schematische Darstellung einer Vorrichtung zum Erzeugen eines Flächenmusters gemäß der Erfindung.
Fig. 4a bis Fig. 4c zeigen verschiedene Darstellungen eines erfindungsgemäßen Mehrschichtkörpers.
Fig. 5 zeigt eine Darstellung eines erfindungsgemäßen Mehrschichtkörpers für ein weiteres Ausführungsbeispiel der Erfindung.
Fig. 6 zeigt eine Schnittdarstellung eines Mehrschichtkörpers.
Fig. 7 zeigt eine weitere Schnittdarstellung eines Mehrschichtkörpers.
Fig. 8 zeigt eine weitere Schnittdarstellung eines Mehrschichtkörpers.
Fig. 9a bis Fig. 9c zeigen Darstellungen erfindungsgemäßer Mehrschichtkörper für weitere Ausführungsbeispiele der Erfindung.
Fig. 10 zeigt einen erfindungsgemäßen Mehrschichtkörper mit einem Moiré-Muster für ein weiteres Ausführungsbeispiel der Erfindung.
Fig. 11 zeigt einen Schnitt durch einen erfindungsgemäßen Mehrschichtkörper für ein weiteres Ausführungsbeispiel der Erfindung.

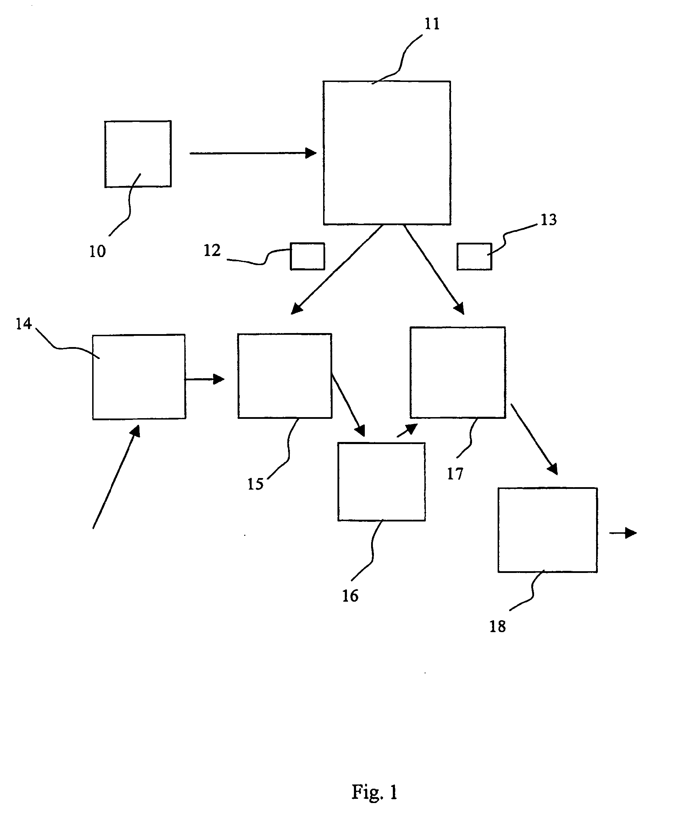

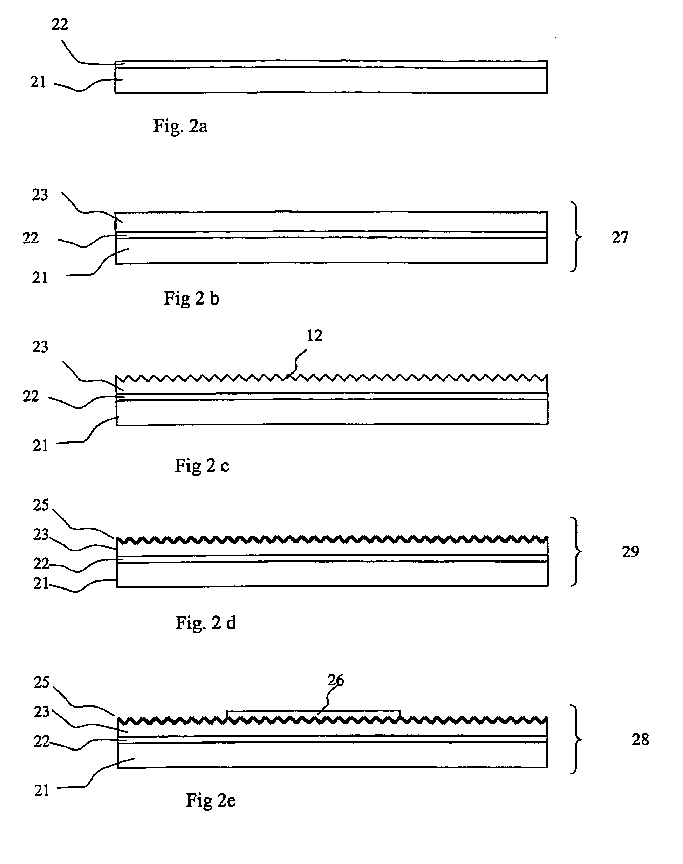

Der Ablauf des erfindungsgemäßen Verfahrens wird im folgenden anhand der Figuren Fig. 1 und Fig. 2a bis Fig. 2e erläutert.

Fig. 1 zeigt mehrere Bearbeitungsstationen 14, 15, 16, 17 und 18 sowie eine Berechnungseinrichtung 11.

Die Bearbeitungsstationen 14, 15, 16, 17 und 18 führen Prozessschritte durch, mittels denen eine gemäß eines Flächenmusters 10 ausgeformte musterförmige Schicht aus einem reflektierenden Material auf einer Basisfolie erzeugt wird. Die Berechnungseinheit 11 generiert aus dem vorliegenden Flächenmuster 10 eine Spezifikation eines mikroskopischen Oberflächenmusters 12 und ein zugeordnetes Flächenmuster 13. Das Flächenmuster 13 beschreibt, in welcher Form eine Drucksubstanz musterförmig auf ein Substrat, in dessen Oberfläche die mikroskopische Oberflächenstruktur 12 repliziert ist, aufgebracht werden muss, um letztendlich einen Drucksubstanz-Auftrag gemäß des Flächenmusters 10 zu erzielen. Wie im späteren noch detailliert beschrieben, ergibt sich hierbei die Feinstrukturierung des Flächenmusters 10 durch die jeweils lokal gemäß des Flächenmusters 13 aufgebrachte Auftragsmenge an Drucksubstanz und die jeweiligen lokalen Reliefparameter der mikroskopischen Oberflächenstruktur 12.

Der Bearbeitungsstation 14 wird der in Fig. 2a gezeigte Folienkörper zugeführt. Dieser Folienkörper besteht aus einer Trägerschicht 21 und einer Ablöse- und/oder Schutzlackschicht 22, die in einem hier nicht gezeigten Verfahrensschritt auf die Trägerfolie 21 aufgebracht ist. Bei der Trägerfolie 21 handelt es sich beispielsweise um eine Polyesterfolie einer Dicke von etwa 12 µm bis 50 µm. Die Ablöse- und/oder Schutzlackschicht 22 hat in etwa eine Dicke von 0,3 bis 1,2 µm. Auf diese Schicht könnte auch verzichtet werden.

Die Bearbeitungsstation 14 trägt auf den zugeführten Folienkörper nun eine Replizierschicht 23 auf. Die Replikationsschicht 23 besteht hierbei vorzugsweise aus einem transparenten, thermoplastischen Kunststoffmaterial, das beispielsweise mittels eines Druckverfahrens vollflächig auf den zugeführten Folienkörper aufgebracht wird.

Der Replizierlack hat hierbei beispielsweise folgende Zusammensetzung:

| Komponentengewichtsteile | |
|---|---|
| hochmolekulares PMMA-Harz | 2000 |
| Silikonalkyd ölfrei | 300 |
| nichtionisches Netzmittel | 50 |
| Niedrigviskose Nitrocellulose | 750 |
| Methylethylketon | 1200 |
| Toluol | 2000 |
| Diacetonalkohol | 2500 |

Der Auftrag der Replizierschicht erfolgt beispielsweise mit einer Linienraster-Tiefdruckwalze mit einem Auftragegewicht von 2,2 g/m² nach Trocknung. Die Trocknung erfolgt im Trockenkanal bei einer Temperatur von 100 bis 120 Grad Celsius.

Der so gebildete Folienkörper 27 (Fig. 2b) wird nun der Bearbeitungsstation 15 zugeführt.

Bei der Bearbeitungsstation 15 handelt es sich um eine Replizierstation, die die mikroskopische Oberflächenstruktur 12 in die Replizierschicht 23 repliziert.

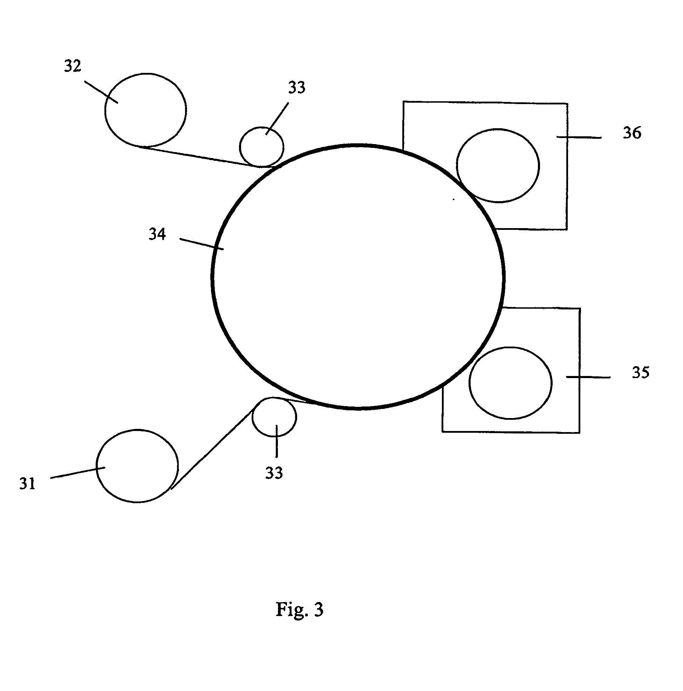

Die Replikation kann hierbei mittels eines Prägewerkzeugs erfolgen. Es ist jedoch auch möglich, dass die Replikation mittels eines UV-Replikationsverfahrens durchgeführt werden kann, wie dies später beispielhaft anhand von Fig. 3 erläutert ist.

In die Replizierschicht 23 wird so beispielsweise bei etwa 160 Grad Celsius mittels einer aus Nickel bestehenden Matrize die mikroskopische Oberflächenstruktur 12 eingeprägt. Zum Prägen der mikroskopischen Oberflächenstruktur 12 wird die Matrize vorzugsweise elektrisch aufgeheizt. Vor dem Abheben der Matrize von der Replizierschicht 23 nach der Prägung kann die Matrize wieder abgekühlt werden. Nach Einprägung der mikroskopischen Oberflächenstruktur 12 erhärtet der Replizierlack durch Vernetzen oder in sonstiger Weise.

Fig. 2c zeigt nun den Mehrschichtkörper 27 nach Bearbeitung durch die Bearbeitungsstation 15. Wie in Fig. 2c gezeigt, ist nun in der Oberfläche der Replizierschicht 23 die mikroskopische Oberflächenstruktur 12 abgeformt. Der derart bearbeitete Folienkörper kann nun der Bearbeitungsstation 16 zugeführt werden.

Die Bearbeitungsstation 16 beschichtet den ihr zugeführten Folienkörper mit einer dünnen Reflexionsschicht 25. Bei der Reflexionsschicht 25 handelt es sich vorzugsweise um eine dünne, aufgedampfte Metallschicht oder um eine HRI-Schicht (HRI = High Refraction Index). Als Materialien für die Metallschicht kommen im wesentlichen Chrom, Aluminium, Kupfer, Eisen, Nickel, Silber, Gold oder eine Legierung mit diesen Materialien in Frage.

Auf die Reflexionsschicht 25 kann auch verzichtet werden. Das Aufbringen der Reflexionsschicht 25 erfolgt vorzugsweise dann, wenn die folgenden Schritte z. B. eine Teilmetallisierung, beispielsweise durch Aufbringen eines Resistlacks und einen Ätzschritt, umfassen. Das Aufbringen der Reflexionsschicht 25 kann insbesondere dann entfallen, wenn leitfähige Polymere verdruckt werden. In diesem Fall besteht die Replikationsschicht aus einem ausgehärtetem Harz (z. B. UV-vemetzbares Harz, 2K-Lack), der durch das Aufbringen des leitfähigen Polymers nicht mehr angelöst wird, so dass es zu keiner Wechselwirkung zwischen dem repliziertem Lacksystem und dem verdruckten System kommt.

Fig. 2d zeigt nun einen Folienkörper 29 nach Bearbeitung durch die Bearbeitungsstation 16. Der Folienkörper 29 weist neben der Trägerschicht 21, der Ablöse- und/oder Schutzlackschicht 22 und der Replizierschicht 23 eine vollflächig aufgedampfte Reflexionsschicht 25 auf. Der Folienkörper 29 wird nun der Bearbeitungsstation 17 zugeführt. Die Bearbeitungsstation 17 trägt auf den Folienkörper 29 mittels eines Druckverfahrens eine Drucksubstanz mit geeigneter Viskosität und Affinität musterförmig gemäß des Flächenmusters 13 auf. Als Druckverfahren wird von der Bearbeitungsstation 17 vorzugsweise ein Tiefdruckverfahren verwendet. So erfolgt der Aufdruck der Drucksubstanz 26 beispielsweise mit einer Tiefdruckrasterwalze, die eine Vielzahl von Näpfchen aufweist, die einen Farbauftrag gemäß des Flächenmusters 13 bewirken.

Es ist hier jedoch auch möglich, das Auftragen der viskosen Drucksubstanz 26 mittels eines anderen Druckverfahrens, beispielsweise mittels eines Offset-, Hochdruck-, Siebdruck- oder Flexodruckverfahrens durchzuführen.

Fig. 2e zeigt nun einen Folienkörper 28 nach der Bearbeitung durch die Bearbeitungsstation 17. Wie in Fig. 2e gezeigt, wird die Oberfläche des Folienkörpers 29 bereichsweise von der Drucksubstanz 26 bedeckt. Der Bedeckungsbereich, den die Drucksubstanz 26 einnimmt, entspricht hierbei nicht dem Auftragebereich, in dem die Drucksubstanz durch die Bearbeitungsstation 17 auf die Oberfläche des Folienkörpers 29 aufgebracht ist. Der Bedeckungsbereich wird vielmehr durch die jeweils lokal aufgebrachte Auftragemenge an Drucksubstanz und die jeweiligen lokalen Reliefparameter der mikroskopischen Oberflächenstruktur 12 bestimmt, die, wie in den Figuren 2d oder 2e gezeigt, auch nach dem Aufbringen der Reflexionsschicht 25 noch in der Oberfläche der Reflexionsschicht 25 abgeformt ist.

Bei der Drucksubstanz 26 handelt es sich um einen Ätzresist, vorzugsweise auf Basis von Vinylchlorid/Vinylacetat-Copolymer.

Der Folienkörper 28 wird nun der Bearbeitungsstation 18 zugeführt. Bei der Bearbeitungsstation 18 handelt es sich um eine Demetallisierungsstation, die die nicht von Replizierlack bedeckten Bereiche der Reflexionsschicht 25 mittels Säure oder Lauge entfernt.

Nach dem Durchlaufen der Bearbeitungsstation 18 kann der Folienkörper 28 noch weitere Wasch-, Trocknungs- und Beschichtungsstationen durchlaufen. So ist es dann beispielsweise auch möglich, dass auf dem Folienkörper 28 im folgenden noch weitere Dekor- und/oder Klebeschichten aufgebracht werden. Weiter ist es natürlich auch möglich, vor dem Aufbringen der Replizierschicht 23 noch weitere Schichten auf dem von den Schichten 21 und 22 gebildeten Folienkörper aufzubringen, so dass der Folienkörper 28 beispielsweise als Teil einer Thermo-Transferfolie, einer Prägefolie oder einer Laminierfolie mit rein optischen oder funktionellen Elementen Verwendung finden kann.

Es ist auch möglich, dass die Bearbeitungsstation 17 anstelle eines Ätzresists ein Ätzmittel auf die Reflexionsschicht 25 als Drucksubstanz aufträgt. Weiter ist es auch möglich, dass die Beschichtung mit der Reflexionsschicht 25 nicht vor dem Aufbringen der Drucksubstanz 26, sondern erst nach dem Aufbringen der Drucksubstanz 26 erfolgt. So kann die Drucksubstanz 26 beispielsweise eine Waschmaske bilden, die nach einer vollflächigen Beschichtung die partielle Entfernung der Reflexionsschicht 25 durch einen Waschvorgang ermöglicht.

Gemäß eines weiteren Ausführungsbeispiels der Erfindung wird auf die Bearbeitungsstationen 16 und 18 verzichtet, so dass durch die in Fig. 1 gezeigte Installation nunmehr eine hochauflösende, nach dem Flächenmuster 10 ausgeführte Dekorlage auf einem Folienkörper erzeugt wird. Als Drucksubstanz kann hier eine übliche Druckfarbe verwendet werden, die beispielsweise aus einem Lösungsmittel mit 2 bis25 % Festkörper besteht.

Weiter ist es möglich, als Drucksubstanz Polymere aufzubringen, mittels denen organische Halbleiterschaltungen realisiert werden. So können beispielsweise als Drucksubstanz organische Elektrodenmaterialien wie Polyanilin oder Polypyrrol, organische Halbleitermaterialien wie Polythiophen oder Isolatoren wie Polyphenylphenol verwendet werden. Mittels des Aufdrucks einer oder mehrer derartiger Funktionspolymerschichten lassen sich beispielsweise organische Feldeffekttransistoren (OFETs) realisieren.

Hierbei ist es natürlich wesentlich, dass bei dem Audruck der Funktionspolymerschicht(en) auf etwaige Auswirkungen einer darunterliegenden metallischen und damit leitenden Reflexionsschicht geachtet wird. Eine derartige metallische Reflexionsschicht ist in ihrer Formgebung damit so zu gestalten, dass sie die elektrischen Wechselwirkungen der Funktionpolymerschichten nicht beeinflusst (z. B. Kurzschluß) oder eine Funktion in der durch die Funktionspolymerschichten realisierten elektrischen Schaltung erbringt.

Fig. 3 zeigt ein weiteres Ausführungsbeispiel einer Vorrichtung zum Erzeugen des Flächenmusters 10.

Fig. 3 zeigt einen Zentralzylinder 34, zwei Rollen 31 und 32, eine Replizierstation 35, eine Druckstation 36 und zwei Führungsrollen 33.

Die Folienbahn wird von der Rolle 31 über den Zentralzylinder 34 zu der Rolle 32 geführt. Die Folienbahn besteht hierbei vorzugsweise aus einem Mehrschichtkörper, der mindestens eine Trägerschicht, beispielsweise bestehend aus einer 19 µm dicken PET-Folie und eine auf dieser aufgebrachten Replizierschicht aufweist. Natürlich ist es auch möglich, dass dieser Mehrschichtkörper noch eine Vielzahl weitere Schichten umfasst.

Die Replizierstation 35 repliziert, wie bereits anhand von Fig. 1 erläutert, mittels eines Prägewerkzeugs die mikroskopische Oberflächenstruktur 12 in die Replizierschicht der Folienbahn.

Weitere Vorteile sind hier erzielbar, wenn anstelle des in Fig. 1 beschriebenen Replizierverfahrens von der Replizierstation 35 ein UV-Replizierverfahren verwendet wird. Hierzu ist es vorteilhaft, an dem Zentralzylinder 34 vor der Replizierstation 35 eine Beschichtungsstation anzuordnen, die einen UV-Replizierlack auf die von der Rolle 31 zugeführte Folienbahn aufträgt. Die Replizierstation 35 enthält eine Maskenzylinder, der in den noch flüssigen UV-Replizierlack eintaucht und durch Bestrahlung des UV-Replizierlacks den UV-Replizierlack gemäß des Flächenmusters 12 aushärtet. Durch ein derartiges Replizierverfahren lassen sich sehr konturscharfe Oberflächenstrukturen mit einer großen Profiltiefe erzeugen. Weitere Vorteile bestehen darin, dass keine thermische Verformung der Folienbahn auftritt. Insbesondere lassen sich so auch rechteckförmige Profilformen in hoher Qualität erzeugen.

Die Druckstation 36 weist eine Druckwalze auf, mittels der eine Drucksubstanz mit geeigneter Viskosität gemäß dem Flächenmuster 13 musterförmig und passergenau auf die mit der mikroskopischen Oberflächenstruktur 12 versehene Folienbahn aufgebracht wird.

Durch die Verwendung eines Zentralzylinders wird hier erreicht, dass die Passergenauigkeit des Auftrags der viskosen Drucksubstanz auf die mikroskopische Oberflächenstruktur 12 weiter verbessert wird. Um das hochauflösende Flächenmuster 10 zu erzeugen, ist es wesentlich, dass das musterförmige Aufbringen der Drucksubstanz gemäß des Flächenmusters 13 auf die mikroskopische Oberflächenstruktur 12 passergenau erfolgt, da ansonsten die Qualität des Ergebnisses absinkt und die gewünschte Auflösung nicht erzielt werden kann.

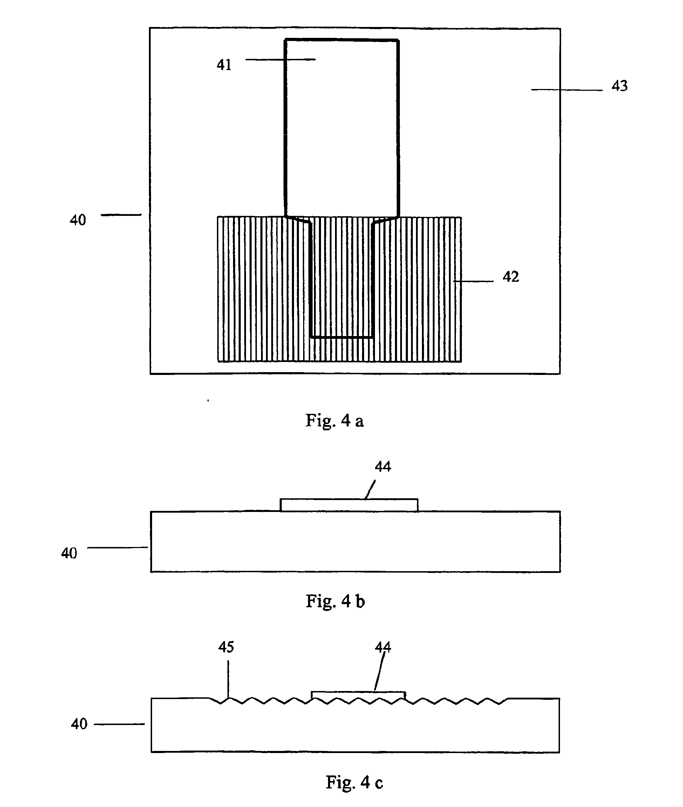

Anhand der Figuren Fig. 4a, Fig. 4b und Fig. 4c wird nun beispielhafte die Erzeugung eines Flächenbereiches 41 eines Flächenmusters hoher Auflösung erläutert.

Die Figuren Fig. 4a, Fig. 4b und Fig. 4c zeigen ein Substrat 40 mit zwei Oberflächenbereichen 43 und 42. In dem Oberflächenbereich 42 ist eine mikroskopische Oberflächenstruktur 45 mit einer Vielzahl von Rillen repliziert. In dem Oberflächenbereich 43 ist die Oberfläche des Substrates 40 glatt und weist keine mikroskopische Rillenstruktur auf.

Auf das Substrat 40 wird nun eine Drucksubstanz 44 musterförmig in Form eines rechteckförmigen Striches konstanter Dicke mittels eines Druckverfahrens aufgebracht. Im Flächenbereich 42 wird die Verlaufsform der aufgebrachten Drucksubstanz von den lokalen Reliefparameter der mikroskopischen Oberflächenstruktur 45 beeinflusst. Wie in Fig. 4c dargestellt, ergibt sich durch die Orientierung der Rillen der mikroskopischen Oberflächenstruktur 42 ein asymmetrischer Verlauf der jeweils aufgebrachten mikrofeinen Drucksubstratmenge, so dass trotz Auftrags in gleicher Dicke die Breite des Flächenbereiches 41 im Bereich 42 (Fig. 4c) geringer als im Bereich 41 (Fig. 4b) ist.

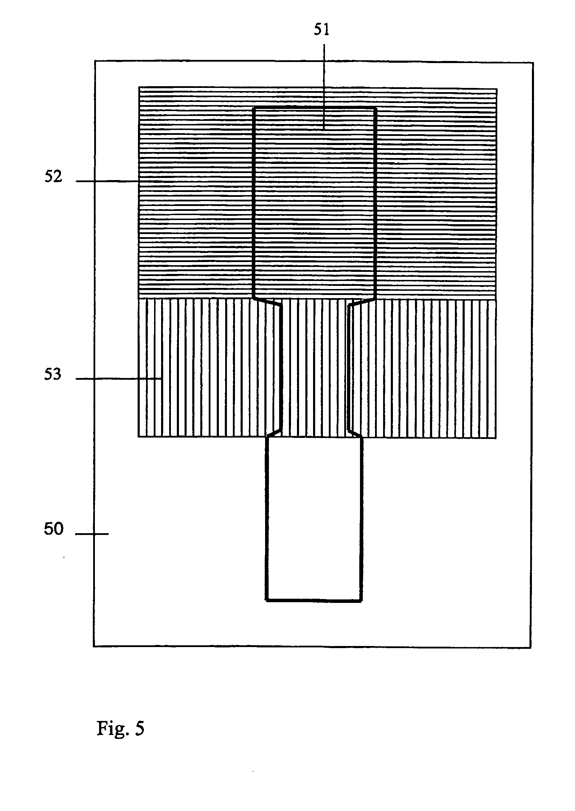

Fig. 5 verdeutlicht nun ein weiteres Ausführungsbeispiel der Erfindung, bei dem mittels Variation der Orientierungsrichtung der Rillen der mikroskopischen Oberflächenstruktur eine Feinstrukturierung des Flächenmusters bewirkt wird.

Fig. 5 zeigt ein Substrat 50, das mehrere Bereiche 52, 53 und 54 aufweist, in denen, wie in Fig. 5 schematisch dargestellt, die Rillen der mikroskopischen Oberflächenstruktur unterschiedliche Orientierung haben.

Auf dem Substrat 50 wird nun ein Drucksubstrat in Form eines rechteckförmigen Striches konstanter Breite aufgebracht. Wie in Fig. 5 gezeigt, ergibt sich durch den Einfluss der mikroskopischen Oberflächenstruktur hieraus ein Flächenmuster 51 in der in Fig. 5 gezeigten Form.

Die Breite eines Flächenbereiches des Flächenmusters 51 wird so wesentlich durch die Wahl des Winkels zwischen der Längsachse des Flächenbereichs und der Orientierungsrichtung des zugeordneten Teils der mikroskopischen Oberflächenstruktur bestimmt.

In dem Bereich 52 ist in die Oberfläche des Substrates 50 ein Sinusgitter mit einer Spatialfrequenz von 100L/mm und einer Profiltiefe von 400 nm abgeformt, wobei die Orientierungsrichtung der Rillen des Sinusgitters um 90 Grad gegenüber der Längsachse des strichförmigen Drucksubstanz-Auftrags gedreht ist. In dem Bereich 53 ist ein Sinusgitter mit einer Spatialfrequenz von 100L/mm und einer Profiltiefe von 400 nm in der Oberfläche des Substrates 50 abgeformt, wobei die Orientierungsrichtung der Rillen des Sinusgitters der Längsachse des strichförmigen Drucksubstanz-Auftrags entspricht. Im Bereich 54 ist die Oberfläche unstrukturiert.

Wie in Fig. 5 gezeigt, wird die Breite der Flächenbereiche des Flächenmusters 51 wesentlich durch den Winkel zwischen der Längsachse des Flächenbereiches und der Orientierungsrichtung des zugeordneten Teils der mikroskopischen Oberflächenstruktur bestimmt. Sind, wie im Bereich 52, die Orientierungsrichtung des Gitters und die Längsachse des Flächenbereiches um 90 Grad gegeneinander verdreht, wird die Breite des Flächenbereiches um ca. 15 Prozent gegenüber der unstrukturierten Fläche verbreitert. Stimmt die Orientierungsrichtung der Oberflächenstruktur und die Längsachse des Flächenbereiches überein, erfolgt eine Verjüngung des Flächenbereichs um ca. 15 Prozent gegenüber der unstrukturierten Fläche .

Besonders gute Ergebnisse bei der Umsetzung der oben beschriebenen Vorgehensweise lassen sich dann erzielen, wenn als Oberflächenstrukturen Sinusgitter mit einer Spatialfrequenz von 100 bis 600 L/mm und einer Profiltiefe von 400 nm bis1200 nm. in Verbindung mit einer Drucksubstanz mit einer Viskosität von 100 mPas eingesetzt werden.

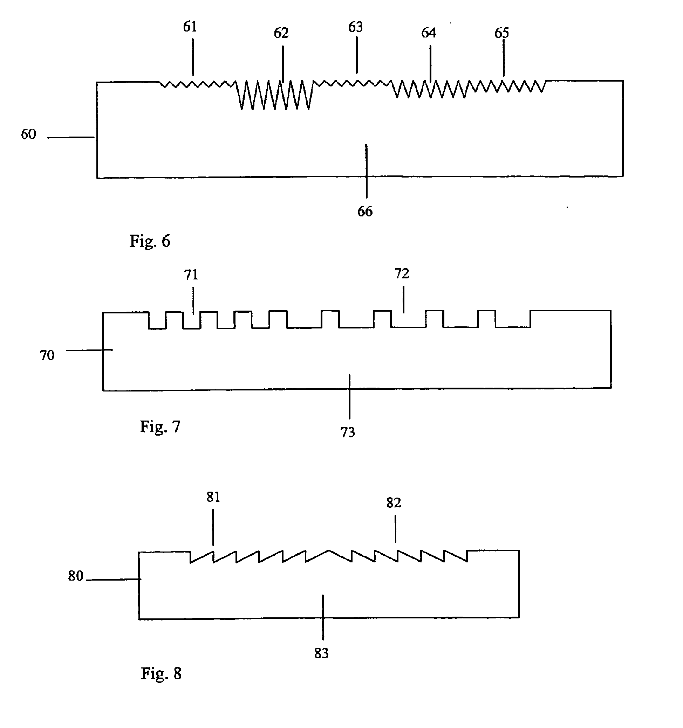

Die Figuren Fig. 6 bis Fig. 9 zeigen nun mehrere Ausführungsbeispiele weiterer mikroskopischer Oberflächenstrukturen, mittels denen ein hochauflösendes Flächenmuster gemäß des erfindungsgemäßen Verfahrens herstellbar ist:

Fig. 6 zeigt ein Substrat 60, in dessen Oberfläche eine mikroskopische Oberflächenstruktur 66 repliziert ist. Wie in Fig. 6 gezeigt, variiert die Profiltiefe der mikroskopischen Oberflächenstruktur 66 in den Bereichen 61, 62, 63, 64 und 65. Die Feinstrukturierung eines Flächenmusters wird so im Bereich der Oberflächenstruktur 66 nicht nur, wie anhand von Fig. 5 beschrieben, durch die Variation der Orientierungsrichtung der Rillen der mikroskopischen Oberflächenstruktur 66 beeinflusst, sondern ebenfalls durch die Variation der Profiltiefe der mikroskopischen Oberflächenstruktur. Durch eine Vergrößerung der Profiltiefe lässt sich so beispielsweise der Oberflächenanteil des Substrats, der von einem mikrofeinen Drucksubstanz-Tropfen benetzt wird, verringern. So ist es beispielsweise vorteilhaft, in dem Bereich 53 eine größere Profiltiefe als in dem Bereich 52 vorzusehen.

Fig. 7 zeigt ein Substrat 70, in dessen Oberfläche eine mikroskopische Oberflächenstruktur 73 repliziert ist. Wie in Fig. 7 gezeigt, ist in den Bereichen 71 und 72 das Tastverhältnis von Vertiefungen zu Erhöhungen der Reliefstruktur unterschiedlich. Hierdurch wird bewirkt, dass in dem Bereich 72 das Volumen der Vertiefungen höher als in dem Bereich 71 ist, wodurch ein dem Effekt der Vertiefung der Profiltiefe ähnlicher Effekt erzielt werden kann.

Fig. 8 zeigt ein Substrat 80, in dessen Oberfläche eine mikroskopische Oberflächenstruktur 83 repliziert ist. Bei dieser asymmetrischen Oberflächenstruktur handelt es sich um ein Sägezahngitter. Durch ein derartiges Sägezahngitter wird der Effekt erzielt, dass die Zentrierung des auf diese Oberflächenstruktur aufgebrachten Drucksubstrat-Auftrags verändert wird. So wird beispielsweise in dem Bereich 81 die Zentrierung des Drucksubstratauftrags etwas nach links verzogen und in dem Bereich 82 die Zentrierung des auf diesen Bereich aufgebrachten Farbauftrags etwas nach rechts verzogen. Damit wird letztendlich eine Vergrößerung der Distanz zwischen Flächenbereichen des Flächenmusters in den Bereichen 81 und 82 erzielt.

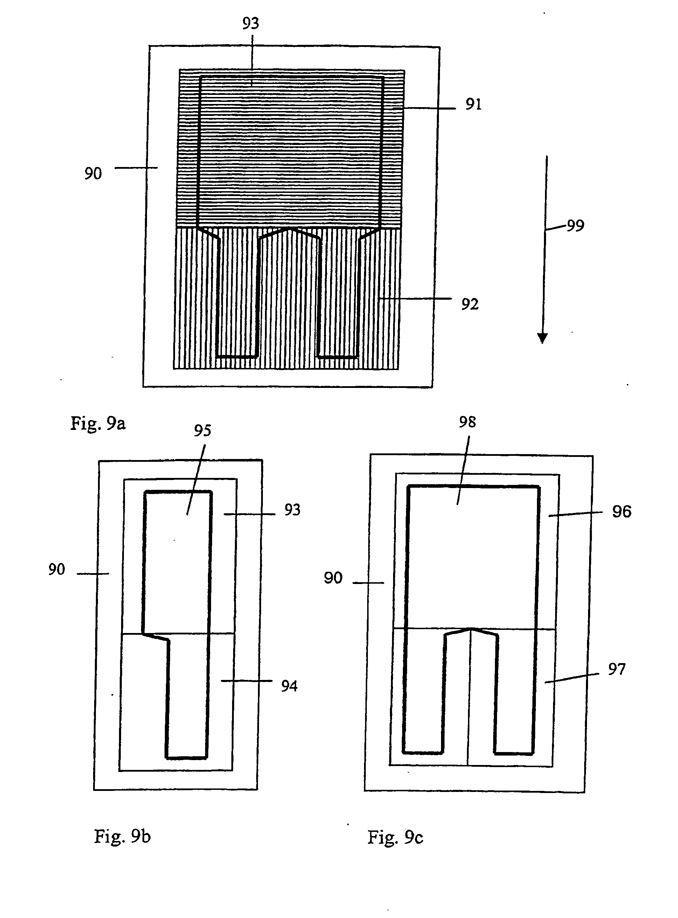

Im folgenden werden anhand der Figuren Fig. 9a bis Fig. 9c mehrere Ausführungsbeispiele der Erfindung beschrieben, bei denen die anhand der Figuren Fig. 5 bis Fig. 8 erläuterten Effekte zum Einsatz kommen.

Fig. 9a zeigt ein Substrat 90, und ein auf dem Substrat 90 erzeugtes hochauflösendes Flächenmuster 93. In den Bereichen 91 und 92 sind unterschiedliche mikroskopische Oberflächenstrukturen in der Oberfläche des Substrates 90 abgeformt. So ist in dem Bereich 92 eine mikroskopische Oberflächenstruktur abgeformt, deren Rillen gemäß einer Richtung 99 orientiert sind, die eine Spatialfrequenz vorzugsweise im Bereich von 100L/mm aufweist und deren Profiltiefe im Bereich von 600 nm liegt. In dem Bereich 91 ist eine mikroskopische Oberflächenstruktur abgeformt, deren Rillen um 90 Grad gegenüber den Rillen der Oberflächenstruktur im Bereich 92 verdreht sind, deren Spatialfrequenz bevorzugt in dem Bereich von 100Umm liegt und die bevorzugt eine Profiltiefe von 600 nm besitzt.

Auf das Substrat 90 wird nun eine Drucksubstanz in Form zweier paralleler, in Richtung 99 orientierter Linien aufgebracht. Durch die Reliefparameter der mikroskopischen Oberflächenstruktur in den Bereichen 91 und 92 wird erreicht, dass im Bereich 91 das Flächenmuster 99 einen vollflächigen Oberflächenbereich ausformt und in dem Bereich 92 das Flächenmuster 93 zwei dünne, in geringem Abstand beabstandete Schenkel ausformt (siehe Fig. 9a). Vorteilhaft ist hierbei, dass ein sehr geringer Abstand zwischen den Schenkeln des Flächenbereiches 92 erzielbar ist. So kann dieser Abstand beispielsweise 30 µm oder weniger betragen.

Fig. 9b zeigt das Substrat 90 und ein auf dem Substrat 90 erzeugtes Flächenmusters 95 hoher Auflösung. In Bereichen 93 und 94 sind in der Oberfläche des Substrats 90 mikroskopische Oberflächenstrukturen mit unterschiedlichen Reliefparametern abgeformt. In dem Bereich 93 ist eine mikroskopische Oberflächenstruktur abgeformt, deren Rillen gemäß der Richtung 99 orientiert sind und die ein symmetrisches Reliefprofil mit einer Spatialfrequenz im Bereich von 100bis 600Umm und einer Profiltiefe in dem Bereich von 400 bis 1100 nm.aufweist. In dem Bereich 94 ist eine mikroskopische Oberflächenstruktur abgeformt, deren Orientierungsrichtung mit der der Oberflächenstruktur in dem Bereich 93 übereinstimmt, die im Gegensatz zu der Oberflächenstruktur im Bereich 93 jedoch eine asymmetrische Profilform, beispielsweise wie anhand von Fig. 8 erläutert, aufweist.

Wird nun auf die Flächenbereiche 93 und 94 Drucksubstanz in Form einer dünnen, in Längsrichtung des Substrates orientierten Linie aufgebracht, so ergibt sich der in Fig. 9b gezeigte Effekt einer asymmetrischen Verjüngung des erzeugten Flächenmusters im Bereich 94.

Dieser Bereich kann, wie in Fig. 9c dargestellt, zur Erzeugung zweier sehr nahe beieinander liegenden Linien ausgenutzt werden.

Fig. 9c zeigt so das Substrat 90, auf dem ein Flächenmusters 98 hoher Auflösung erzeugt ist. In dem Bereich 96 ist die mikroskopische Oberflächenstruktur des Bereiches 93 nach Fig. 9b in dem Substrat 90 abgeformt. In dem Bereich 97 ist, wie in dem Bereich 94 nach Fig. 9b, eine Oberflächenstruktur mit einem asymmetrischen Reliefprofil abgeformt. Hierbei ist in dem rechten Teilbereich des Bereiches 97 das asymmetrische Profil wie in dem Bereich 82 nach Fig. 8 orientiert und in dem linken Teilbereich des Bereiches 97 wie in dem Bereich 81 nach Fig. 8 orientiert.

Wird nun ein Drucksubstrat in Form zweier dünner, parallel zueinander liegender Linien auf die Bereiche 96 und 97 aufgebracht, so wird das in Fig. 9c dargestellte Flächenmuster 98 generiert.

Durch eine derartige Vorgehensweise lassen sich Schenkel in dem Bereich 97 erzeugen, die nur 25µm voneinander beabstandet sind.

Durch eine Kombination der in den Figuren 5 bis 9c geschilderten Techniken lassen sich vielfältige hochauflösende Flächenmuster erzeugen. So werden die oben geschilderten Zusammenhänge beispielsweise in der Berechnungseinrichtung 11 codiert, so dass zu einem vorgegebenen, vordefinierten Flächenmuster hoher Auflösung die hierfür notwendige Gestaltung der mikroskopischen Oberflächenstruktur und des zugeordneten Flächenmusters, in dem der Drucksubstanz-Auftrag zu erfolgen hat, berechnet werden kann.

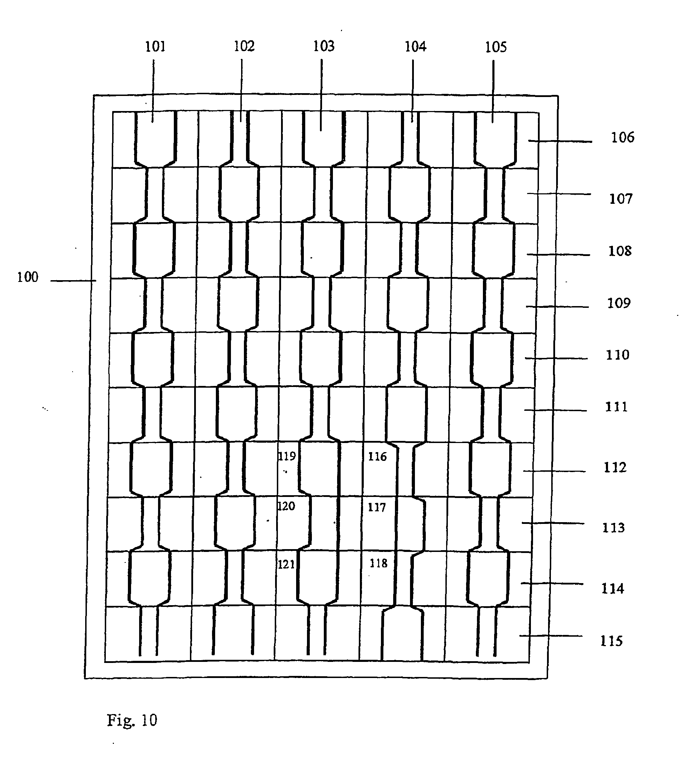

Fig. 10 zeigt nun eine bevorzugte Ausführungsform eines mit der Erfindung generierbaren Flächenmusters. Fig. 10 zeigt ein Substrat 100, auf dem ein Flächenmuster mit mehreren parallel zueinander liegenden Flächenbereichen 101 bis 105 erzeugt ist. Auf der Oberfläche des Substrates 100 ist eine mikroskopische Oberflächenstruktur abgeformt, die sich aus einer Vielzahl von schachbrettartig angeordneten Teilstrukturen zusammensetzt. In jeder der Teilstrukturen unterscheiden sich die Reliefparameter von den Reliefparametern der umgebenen Teilstrukturen.

Fig. 10 zeigt so beispielhaft mehrere Teilstrukturen 106 bis 115. Die Teilstrukturen 106, 108, 110, 112 und 114 werden von einer mikroskopischen Struktur gebildet, wie sie in dem Bereich 52 nach Fig. 5 vorgesehen ist. Die Teilstrukturen 107, 109, 111, 113 und 115 werden jeweils von einer mikroskopischen Struktur gebildet, wie sie in dem Bereich 52 nach Fig. 5 vorgesehen ist. Hierdurch ergibt sich bei Auftrag eines Drucksubstrats in Form einer dünnen Linie auf die Bereiche der Teil-Strukturen 106 bis 115 eine in ihrer Dicke variierenden Linie, wie sie in Fig. 10 in den Flächenbereichen 101, 102 und 105 des Flächenmusters gezeigt ist.

Durch eine Abänderung der Oberflächenstruktur von Teilstrukturen ist es nun möglich, die Gleichmäßigkeit des Musters zu unterbrechen und hierbei jedoch den mittleren, für das menschliche Auge auflösbaren Eindruck (mittlere Bedeckungsfläche durch Drucksubstrat) konstant zu halten.

Dies ist in Fig. 10 beispielhaft anhand der Veränderung der Strukturen 117 und 120 aufgezeigt: Die Teilstrukturen 119, 116, 121 und 118 der mikroskopischen Oberflächenstruktur sind noch nach dem oben geschilderten Schema ausgeführt. Die Teilstrukturen 120 und 117 weisen jeweils zwei Teilbereiche auf, in denen die Orientierung der Rillen um 90 Grad gegenüber einander verschoben sind. Hierdurch wird erzielt, dass im linken Teilbereich der Teilstruktur 117 die Liniendicke reduziert und im rechten Teil der Teilstruktur 120 die Liniendicke erhöht wird. Die Bedeckungsfläche bleibt damit im Mittel gleich, die Veränderung der Mikrostruktur kann jedoch als Moiré-Muster durch ein entsprechendes Auswertegerät erkannt und als Zusatzinformation ausgewertet werden.

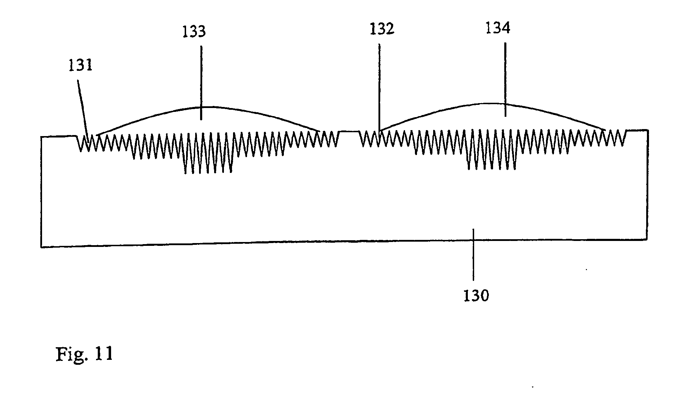

Fig. 11 zeigt nun eine Möglichkeit, mittels der oben geschilderten Techniken die Dicke der Drucksubstanz-Schicht auf vordefinierte Art zu variieren.

Fig. 11 zeigt ein Substrat 130, in das eine mikroskopische Oberflächenstruktur repliziert ist. In den Bereichen 131 und 132 der mikroskopischen Oberflächenstruktur variiert nun die Profiltiefe der Oberflächenstruktur. Wie in Fig. 11 gezeigt, ist im Zentrum der Bereiche 131 und 132 die Profiltiefe am höchsten und nimmt zu den Begrenzungslinien der Bereich 131 und 132 hin ab.

Wird nun ein hochbrechender Lack als Drucksubstanz auf die Bereiche 131 und 132 aufgebracht, so folgt die Schichtdicke des aufgebrachten Drucksubstrats der Profiltiefe der mikroskopischen Oberflächenstruktur. Durch den Auftrag des hochbrechenden Drucksubstrats auf die Flächenbereiche 131 und 132 werden damit Linsenkörper 133 und 134 erzeugt, die gemäß des vorgegebenen Profiltiefen-Profils der mikroskopischen Oberflächenstruktur konvexe oder konkave Eigenschaften besitzen.

## Patentansprüche

1. Verfahren zum Erzeugen eines Flächemusters (41, 51, 93, 95, 98) hoher Auflösung auf einem Substrat (40, 27, 50, 90,), wobei bei dem Verfahren eine Drucksubstanz (44, 26, 2) mittels eines Druckverfahrens musterförmig auf das Substrat (40, 27, 50, 90) aufgebracht wird,
**dadurch gekennzeichnet,**
**dass** zur Feinstrukturierung des Flächenmusters (41, 51, 93, 95, 98) vor dem Aufbringen der Drucksubstanz in die Oberfläche des Substrats eine mikroskopische Oberflächenstruktur (24, 45, 52, 53, 54, 61 bis 65, 71, 72, 81, 82) mit einer Vielzahl von Rillen repliziert wird, und dass die Feinstrukturierung des Flächenmusters (41, 51, 93, 95, 98) durch die jeweils lokal aufgebrachte Auftragemenge an Drucksubstanz (44, 26) und die jeweiligen lokalen Relief-Parameter der mikroskopischen Oberflächenstruktur (45, 24, 52 bis 54, 63 bis 64, 71, 72, 81, 82), insbesondere Orientierungsrichtung und Profilform, bestimmt wird.

2. Verfahren nach Anspruch 1,
**dadurch gekennzeichnet,**
**dass** die Feinstrukturierung des Flächenmusters (41, 51, 93, 95,98) durch Variationen der Orientierungsrichtung der Rillen der mikroskopischen Oberflächenstruktur (24, 45, 52, 53, 54) bewirkt wird.

3. Verfahren nach einem der vorhergehenden Ansprüche,
**dadurch gekennzeichnet,**
**dass** die Feinstrukturierung des Flächenmusters (93, 95, 98) durch Variationen der Profiltiefe der Rillen der mikroskopischen Oberflächenstruktur (61 bis 65) bewirkt wird.

4. Verfahren nach einem der vorhergehenden Ansprüche
**dadurch gekennzeichnet,**
**dass** die Feinstrukturierung des Flächenmusters (93, 95, 98) durch Variationen der Profilform der Rillen der mikroskopische Oberflächenstruktur (71, 72, 81, 82) bewirkt wird.

5. Verfahren nach einem der vorhergehenden Ansprüche
**dadurch gekennzeichnet,**
**dass** die Breite eines Flächenbereiches des Flächenmusters (41, 51) durch Wahl des Winkels zwischen der Längsachse des Flächenbereiches und der Orientierungsrichtung des zugeordneten Teils der mikroskopischen Oberflächenstruktur (45) bestimmt wird.

6. Verfahren nach einem der vorhergehenden Ansprüche,
**dadurch gekennzeichnet,**
**dass** die Breite eines Flächenbereiches des Flächenmusters (51) variiert wird, indem in dem Flächenbereich Bereiche (52, 53) mit unterschiedlicher Orientierungsrichtung der Oberflächenstruktur vorgesehen werden.

7. Verfahren nach Anspruch 6,
**dadurch gekennzeichnet,**
**dass** die Breite des Flächenbereiches des Flächenmusters (51) variiert wird, indem in dem Flächenbereich mindestens zwei Bereiche (52, 53) mit um 90 Grad gegeneinander verdrehten Orientierungsrichtungen der Oberflächenstruktur vorgesehen werden.

8. Verfahren nach einem der vorhergehenden Ansprüche,
**dadurch gekennzeichnet,**
**dass** die Breite des Flächenbereiches des Flächenmusters (51) variiert wird, indem in dem Flächenbereich Bereiche mit unterschiedlicher Profilform und/oder Profiltiefe der Oberflächenstruktur vorgesehen werden.

9. Verfahren nach einem der vorhergehenden Ansprüche,
**dadurch gekennzeichnet,**
**dass** die Zentrierung eines Flächenbereiches des Flächenmusters (95, 98,) durch eine asymmetrische Profilform im zugeordneten Teil der mikroskopischen Oberflächenstruktur verändert wird.

10. Verfahren nach einem der Ansprüche 5 bis 9,
**dadurch gekennzeichnet,**
**dass** die Breite des Flächenbereiches kleiner als 50 µm ist.

11. Verfahren nach einem der vorhergehenden Ansprüche,
**dadurch gekennzeichnet,**
**dass** mittels der Feinstrukturierung benachbarter Flächenbereiche durch Variation lokaler Relief-Parameter der mikroskopischen Oberflächenstruktur Moiré-Muster (101, 102, 103, 104, 105) erzeugt werden.

12. Verfahren nach einem der vorhergehenden Ansprüche,
**dadurch gekennzeichnet,**
**dass** mittels der Feinstrukturierung durch Variation lokaler Relief-Parameter der mikroskopischen Oberflächenstruktur ein Mikroschrift-Muster erzeugt wird.

13. Verfahren nach einem der vorhergehenden Ansprüche
**dadurch gekennzeichnet,**
**dass** durch Variation der Profiltiefe der Rillen der mikroskopischen Oberflächenstruktur (131, 132) ein Bereich mit vordefiniert variierender Dicke der Drucksubstanz-Schicht (133, 134) erzeugt wird.

14. Verfahren nach Anspruch 13,
**dadurch gekennzeichnet,**
**dass** als Drucksubstanz ein hochbrechender Lack verwendet wird und dass durch die Variation der Profiltiefe der Rillen in dem Bereich ein Linsenkörper erzeugt wird.

15. Verfahren nach einem der vorhergehenden Ansprüche,
**dadurch gekennzeichnet,**
**dass** die Feinstrukturierung des Flächenmusters durch Variation der Reliefparameter der mikroskopischen Oberflächenstruktur bei in etwa konstanter Auftragemenge an Drucksubstanz pro Flächeneinheit bewirkt wird.

16. Verfahren nach einem der vorhergehenden Ansprüche,
**dadurch gekennzeichnet,**
**dass** die mikroskopische Oberflächenstruktur eine Spatialfrequenz von mehr als 50 Rillen/mm, vorzugsweise von 100 bis 1200 mm Rillen/mm, und eine Profiltiefe von weniger als 2 µm, vorzugsweise von 0,2 bis 1,2 µm, aufweist.

17. Mehrschichtkörper (28), der eine Substratschicht (25) und eine auf der Substratschicht angeordnete Musterschicht (26) aufweist, die auf der Substratschicht musterförmig in Form eines Flächenmusters hoher Auflösung ausgeformt ist, wobei die Musterschicht (26) aus einer Drucksubstanz besteht, die mittels eines Druckverfahrens musterförmig auf die Substratschicht aufgebracht ist,
**dadurch gekennzeichnet,**
**dass** in die Oberfläche der Substratschicht zur Feinstrukturierung des Flächenmusters vor dem Aufbringen der Drucksubstanz eine mikroskopische Oberflächenstruktur (24) mit einer Vielzahl von Rillen repliziert ist, wobei die Feinstrukturierung des Flächenmusters durch die jeweils lokal aufgebrachte Auftragemenge an Drucksubstanz und jeweilige lokale Relief-Parameter der mikroskopischen Oberflächenstruktur, insbesondere Orientierungsrichtung und Profilform, bestimmt ist.

18. Mehrschichtkörper nach Anspruch 17,
**dadurch gekennzeichnet,**
**dass** der Mehrschichtkörper eine Folie, insbesondere eine Heißprägefolie oder Laminierfolie ist.

19. Mehrschichtkörper nach einem der Ansprüche 17 bis 18,
**dadurch gekennzeichnet,**
**dass** die Drucksubstanz ein Ätzresist ist.

20. Mehrschichtkörper nach einem der Ansprüche 17 bis 18,
**dadurch gekennzeichnet,**
**dass** die Drucksubstanz ein Ätzmittel ist.

21. Mehrschichtkörper nach einem der Ansprüche 17 bis 18
**dadurch gekennzeichnet,**
**dass** die Drucksubstanz ein organisches Halbleitermaterial enthält.

22. Vorrichtung zum Erzeugen eines Flächenmusters hoher Auflösung auf einem Substrat, wobei die Vorrichtung eine Druckstation (36) zum musterförmigen Aufbringen einer Drucksubstanz auf dem Substrat aufweist,
**dadurch gekennzeichnet,**
**dass** die Vorrichtung eine vor der Druckstation (36) angeordnete Replizierstation (35) zur Feinstrukturierung des Flächenmusters aufweist, die so ausgestaltet ist, dass sie in die Oberfläche des Substrats eine mikroskopische Oberflächenstruktur mit einer Vielzahl von Rillen repliziert, und dass die Druckstation (36) weiter so ausgestaltet ist, dass sie die Drucksubstanz derart auf die mikroskopische Oberflächenstruktur des Substrates aufbringt, dass sich eine vorbestimmte Feinstrukturierung des Flächenmusters durch die jeweils lokal aufgebrachte Auftragemenge an Drucksubstanz und die jeweiligen lokalen Relief-Parameter der mikroskopischen Oberflächenstruktur, insbesondere Orientierungsrichtung und Profilform, ergibt.

23. Vorrichtung nach Anspruch 22,
**dadurch gekennzeichnet,**
**dass** die Druckstation (36) eine Einrichtung zum passergenauen Aufbringen der Drucksubstanz aufweist.

24. Vorrichtung nach Anspruch 22,
**dadurch gekennzeichnet,**
**dass** die Vorrichtung einen Zentralzylinder (34) aufweist, an dem die Replizierstation (35) und die Druckstation (36) angeordnet ist.

## Claims

1. Method for producing a high-resolution surface pattern (41, 51, 93, 95, 98) on a substrate (40, 27, 50, 90), in the method a printing substance (44, 26, 2) being applied to the substrate (40, 27, 50, 90) in the form of a pattern by means of a printing process,
**characterized in that**
in order to structure the surface pattern (41, 51, 93, 95, 98) finely before the application of the printing substance, a microscopic surface structure (24, 45, 52, 53, 54, 61 to 65, 71, 72, 81, 82) having a large number of grooves is replicated in the surface of the substrate, and **in that** the fine structuring of the surface pattern (41, 51, 93, 95, 98) is determined by the respectively locally applied application quantity of printing substance (44, 26) and the respective local relief parameters of the microscopic surface structure (45, 24, 52 to 54, 63 to 64, 71, 72, 81, 82), in particular direction of orientation and profile shape.

2. Method according to Claim 1, **characterized in that** the fine structuring of the surface pattern (41, 51, 93, 95, 98) is effected by means of variations in the direction of orientation of the grooves of the microscopic surface structure (24, 45, 52, 53, 54).

3. Method according to one of the preceding claims, **characterized in that** the fine structuring of the surface pattern (93, 95, 98) is effected by means of variations in the profile depth of the grooves of the microscopic surface structure (61 to 65).

4. Method according to one of the preceding claims, **characterized in that** the fine structuring of the surface pattern (93, 95, 98) is effected by means of variations in the profile shape of the grooves of the microscopic surface structure (71, 72, 81, 82).

5. Method according to one of the preceding claims, **characterized in that** the width of a surface region of the surface pattern (41, 51) is determined by choosing the angle between the longitudinal axis of the surface region and the direction of orientation of the associated part of the microscopic surface structure (45).

6. Method according to one of the preceding claims, **characterized in that** the width of a surface region of the surface pattern (51) is varied by regions (52, 53) having a different direction of orientation of the surface structure being provided in the surface region.

7. Method according to Claim 6, **characterized in that** the width of the surface region of the surface pattern (51) is varied by at least two regions (52, 53) having directions of orientation of the surface structure rotated through 90 degrees with respect to each other being provided in the surface region.

8. Method according to one of the preceding claims, **characterized in that** the width of the surface region of the surface pattern (51) is varied by regions with a different profile shape and/or profile depth of the surface structure being provided in the surface region.

9. Method according to one of the preceding claims, **characterized in that** the centring of a surface region of the surface pattern (95, 98) is varied by means of an asymmetric profile shape in the associated part of the microscopic surface structure.

10. Method according to one of Claims 5 to 9, **characterized in that** the width of the surface region is less than 50 µm.

11. Method according to one of the preceding claims, **characterized in that**, by means of the fine structuring of adjacent surface regions, moiré patterns (101, 102, 103, 104, 105) are produced by means of variation of local relief parameters of the microscopic surface structure.

12. Method according to one of the preceding claims, **characterized in that**, by means of the fine structuring, a micro-text pattern is produced by means of variation of local relief parameters of the microscopic surface structure.

13. Method according to one of the preceding claims, **characterized in that**, by means of variation of the profile depth of the grooves of the microscopic surface structure (131, 132), a region having a predefined varying thickness of the printing substance layer (133, 134) is produced.

14. Method according to Claim 13, **characterized in that** the printing substance used is a highly refractive varnish, and **in that** a lens element is produced by means of the variation of the profile depth of the grooves in the region.

15. Method according to one of the preceding claims, **characterized in that** the fine structuring of the surface pattern is effected by means of variation of the relief parameters of the microscopic surface structure with an approximately constant application quantity of the printing substance per unit area.

16. Method according to one of the preceding claims, **characterized in that** the microscopic surface structure has a spatial frequency of more than 50 grooves/mm, preferably of 100 to 1200 grooves/mm, and a profile depth of less than 2 µm, preferably of 0.2 to 1.2 µm.

17. Multi-layer body (28) which has a substrate layer (25) and a patterned layer (26) arranged on the substrate layer, which is moulded on the substrate layer in the form of a pattern in the form of a high-resolution surface pattern, the patterned layer (26) consisting of a printing substance which is applied to the substrate layer in the form of a pattern by means of a printing process,
**characterized in that**
in order to structure the surface pattern finely before the application of the printing substance, a microscopic surface structure (24) having a large number of grooves is replicated in the surface of the substrate layer, the fine structuring of the surface pattern being determined by the respectively locally applied application quantity of printing substance and the respective local relief parameters of the microscopic surface structure, in particular direction of orientation and profile shape.

18. Multi-layer body according to Claim 17, **characterized in that** the multi-layer body is a film, in particular a hot embossing film or laminating film.

19. Multi-layer body according to one of Claims 17 to 18, **characterized in that** the printing substance is an etch resist.

20. Multi-layer body according to one of Claims 17 to 18, **characterized in that** the printing substance is an etching agent.

21. Multi-layer body according to one of Claims 17 to 18, **characterized in that** the printing substance contains an organic semiconductor material.

22. Device for producing a high-resolution surface pattern on a substrate, the device having a printing station (36) for the application of a printing substance to the substrate in the form of a pattern,
**characterized in that**
the device has a replicating station (35) arranged upstream of the printing station (36) in order to structure the surface pattern finely, which replicating station (35) is configured in such a way that it replicates a microscopic surface structure having a large number of grooves in the surface of the substrate, and **in that** the printing station (36) is also configured in such a way that it applies the printing substance to the microscopic surface structure of the substrate in such a way that the result is predetermined fine structuring of the surface pattern by means of the respectively locally applied application quantity of printing substance and the respective local relief parameters of the microscopic surface structure, in particular direction of orientation and profile shape.

23. Device according to Claim 22, **characterized in that** the printing station (36) has an apparatus for the accurate-register application of the printing substance.

24. Device according to Claim 22, **characterized in that** the device has a central cylinder (34) on which the replicating station (35) and the printing station (36) are arranged.

## Revendications

1. Procédé pour la fabrication d'un motif de surface (41, 51, 93, 95, 98) à haute définition sur un substrat (40, 27, 50, 90), une matière d'impression (44, 26, 2) étant déposée lors du procédé sur le substrat (40, 27, 50, 90), en formant un motif au moyen d'un procédé d'impression,
**caractérisé en ce que**
pour la configuration fine du motif de surface (41, 51, 93, 95, 98), on effectue avant l'apport de la matière d'impression à la surface du substrat, la réplication d'une structure superficielle microscopique (24, 45, 52, 53, 54, 61 à 65, 71, 72, 81, 82) avec une pluralité de sillons, et **en ce que** la configuration fine du motif de surface (41, 51, 93, 95, 98) est déterminée par chaque quantité d'apport de matière d'impression (44, 26) déposée localement et par chacun des paramètres locaux du relief de la structure superficielle microscopique (45, 24, 52 à 54, 63 à 64, 71, 72, 81, 82), en particulier la direction de l'orientation et la forme des profils.

2. Procédé selon la revendication 1,
**caractérisé en ce que**
la configuration fine du motif de surface (41, 51, 93, 95, 98) est obtenue par des variations de la direction de l'orientation des sillons de la structure superficielle microscopique (24, 45, 52, 53, 54).

3. Procédé selon l'une quelconque des revendications précédentes,
**caractérisé en ce que**
la configuration fine du motif de surface (93, 95, 98) est obtenue par des variations de la profondeur du profil des sillons de la structure superficielle microscopique (61 à 65).

4. Procédé selon l'une quelconque des revendications précédentes,
**caractérisé en ce que**
la configuration fine du motif de surface (93, 95, 98) est obtenue par des variations de la forme du profil des sillons de la structure superficielle microscopique (71, 72, 81, 82).

5. Procédé selon l'une quelconque des revendications précédentes,
**caractérisé en ce que**
la largeur d'une zone de surface du motif de surface (41, 51) est déterminée par le choix de l'angle entre l'axe longitudinal de la zone de surface et la direction de l'orientation de la partie correspondante de la structure superficielle microscopique (45).

6. Procédé selon l'une quelconque des revendications précédentes,
**caractérisé en ce que**
la largeur d'une zone de surface du motif de surface (51) est variée, tandis que sont prévues dans les zones (52, 53) de la zone de surface différentes directions d'orientation de la structure superficielle.

7. Procédé selon la revendication 6,
**caractérisé en ce que**
la largeur de la zone de surface du motif de surface (51) est variée, tandis que sont prévues dans la zone de surface au moins deux zones (52, 53) avec des directions d'orientation de la structure superficielle pivotées de 90 degrés l'une par rapport à l'autre.

8. Procédé selon l'une quelconque des revendications précédentes,
**caractérisé en ce que**
la largeur de la zone de surface du motif de surface (51) est variée, tandis que sont prévues dans la zone de surface des zones avec des formes de profil et/ou des profondeurs de profil différentes de la structure superficielle.

9. Procédé selon l'une quelconque des revendications précédentes,
**caractérisé en ce que**
le centrage d'une zone de surface du motif de surface (95, 98) est modifié par une forme de profil asymétrique dans la partie correspondante de la structure superficielle microscopique.

10. Procédé selon l'une quelconque des revendications 5 à 9,
**caractérisé en ce que**
la largeur de la zone de surface est inférieure à 50 µm.

11. Procédé selon l'une quelconque des revendications précédentes,
**caractérisé en ce que**
au moyen de la configuration fine des zones de surface voisines, on élabore un motif moiré (101, 102, 103, 104, 105) par variation des paramètres de relief locaux de la structure superficielle microscopique.

12. Procédé selon l'une quelconque des revendications précédentes,
**caractérisé en ce que**
au moyen de la configuration fine, on élabore un motif de micro inscription par variation des paramètres de relief locaux de la structure superficielle microscopique.

13. Procédé selon l'une quelconque des revendications précédentes,
**caractérisé en ce que**
par variation de la profondeur de profil des sillons de la structure superficielle microscopique (131, 132), on élabore une zone à épaisseur variable de façon prédéfinie de la couche de matière d'impression (133, 134).

14. Procédé selon la revendication 13,
**caractérisé en ce que**
comme matière d'impression on utilise une laque à grande réfringence, et **en ce que** par la variation de la profondeur de profil des sillons dans la zone, on élabore un corps de lentille.

15. Procédé selon l'une quelconque des revendications précédentes,
**caractérisé en ce que**
la configuration fine du motif de surface est obtenue par variation des paramètres de relief de la structure superficielle microscopique avec une quantité d'apport pratiquement constante de matière d'impression par unité de surface.

16. Procédé selon l'une quelconque des revendications précédentes,
**caractérisé en ce que**
la structure superficielle microscopique comprend une fréquence spatiale de plus de 50 sillons / mm, de préférence de 100 à 1 200 sillons / mm, et une profondeur de profil de moins de 2 µm, de préférence de 0,2 à 1,2 µm.

17. Corps multicouche (28) qui comporte une couche de substrat (25) et une couche de motif (26) agencée sur la couche de substrat, qui est conformée en formant un motif sur la couche de substrat, sous la forme d'un motif de surface à haute définition, dans lequel la couche de motif (26) est constituée d'une matière d'impression qui est déposée en formant un motif sur la couche de substrat au moyen d'un procédé d'impression,
**caractérisé en ce que**
l'on effectue à la surface de la couche de substrat la réplication d'une structure superficielle microscopique (24) avec un grand nombre de sillons pour la configuration fine du motif de surface avant l'apport de la matière d'impression, la configuration fine du motif de surface étant déterminée par chaque quantité d'apport de matière d'impression déposée localement et par chacun des paramètres locaux du relief de la structure superficielle microscopique, en particulier la direction de l'orientation et la forme des profils.

18. Corps multicouche selon la revendication 17,
**caractérisé en ce que**
le corps multicouche est une feuille, en particulier une feuille estampée à chaud ou une feuille laminée.

19. Corps multicouche selon l'une quelconque des revendications 17 à 18,
**caractérisé en ce que**
la matière d'impression est résistante à la corrosion.

20. Corps multicouche selon l'une quelconque des revendications 17 à 18,
**caractérisé en ce que**
la matière d'impression est une matière caustique.

21. Corps multicouche selon l'une quelconque des revendications 17 à 18,
**caractérisé en ce que**
la matière d'impression contient une matière semiconductrice organique.

22. Dispositif pour produire un motif de surface à haute définition sur un substrat, ce dispositif comprenant un poste d'impression (36) pour l'apport formant un motif d'une matière d'impression sur le substrat,
**caractérisé en ce que**
le dispositif comprend, disposé devant le poste d'impression (36), un poste de réplication (35) pour la configuration fine du motif de surface, qui est constitué de telle sorte qu'il effectue la réplication, à la surface du substrat, d'une structure superficielle microscopique avec un grand nombre de sillons, et **en ce que** le poste d'impression (36) est en outre constitué de sorte qu'il apporte la matière d'impression sur la structure superficielle microscopique du substrat de manière à obtenir une configuration fine prédéterminée du motif de surface par chaque quantité d'apport de matière d'impression déposée localement et par chacun des paramètres locaux du relief de la structure superficielle microscopique, en particulier la direction de l'orientation et la forme des profils.

23. Dispositif selon la revendication 22,
**caractérisé en ce que**
le poste d'impression (36) comprend une installation pour l'apport exactement adapté de la matière d'impression.

24. Dispositif selon la revendication 22,
**caractérisé en ce que**
le dispositif présente un cylindre central (34) sur lequel sont agencés le poste de réplication (35) et le poste d'impression (36).
